Europäisches Patentamt

European Patent Office

Office européen des brevets

(11) Publication number: **0 480 417 A2**

# EUROPEAN PATENT APPLICATION

(21) Application number: **91117287.2**

(22) Date of filing: **10.10.91**

(51) Int. Cl.⁵: **G06F 15/78**

(30) Priority: **11.10.90 US 596680**

(43) Date of publication of application:
**15.04.92 Bulletin 92/16**

(84) Designated Contracting States:
**DE FR GB IT NL**

(71) Applicant: **LSI LOGIC CORPORATION**
**1551 McCarthy Boulevard**
**Milpitas, CA 95035(US)**

(72) Inventor: **Fuccio, Michael**
**2448 Rockridge Way**
**Santa Clara, California 95051(US)**
Inventor: **Caulk, Robert L.**
**4020 Page Ct.**
**Pleasanton, California 94588(US)**

(74) Representative: **Kahler, Kurt, Dipl.-Ing.**
**Postfach 1249 Gerberstrasse 3**
**W-8948 Mindelheim(DE)**

(54) Memory control architecture for microprocessors.

(57) A microprocessor (100) having a selectable byte-wide PROM interface (104) is disclosed. Instructions can be executed from byte-wide or word-wide (multi-byte-wide) devices, without external glue logic. A selectable byte-gathering feature is provided. Access times for each byte (or word) are programmable through a wait state generator (118) to allow flexibility in choosing from a wide variety of devices with different access times.

FIG.1

Cross-Reference to Related Applications

Attention is directed to copending, commonly-owned EP-Application No. (Attorney Docket No.LS21088EP) entitled TESTABLE RAM ARCHITECTURE IN A MICROPROCESSOR HAVING EMBEDDED CACHE MEMORY, filed on even date herewith by the same Applicants.

TECHNICAL FIELD OF THE INVENTION

The present invention relates to memory interface techniques for microprocessors and, more particularly to aspects of memory interface including byte-gathering, memory control and boot-up.

BACKGROUND OF THE INVENTION

Microprocessors are linked to various forms of memory, including: RAM (Random Access Memory), which is typically used for storing instructions and data being processed; ROM (Read Only Memory), which typically contains boot-up instructions for the microprocessor; and other storage media, which are connected via a general memory interface to the microprocessor. Cache memory is also employed to provide speedier access to instructions and data stored in other, slower forms of memory, and may be embedded on-chip with the microprocessor.

Previous methods of memory interface provide a general handshaking interface at the microprocessor pins, and build the DRAM control logic and byte-gathering (8-bit PROM interface) with external logic.

U.S. Patent No. 4,943,911 shows a system for loading initial program loader routine , and is cited as representative of the general state of the art dealing with memory interface.

DISCLOSURE OF THE INVENTION

It is therefore an object of the present invention to provide flexible byte-gathering capability in a microprocessor.

It is a further object of the present invention to provide flexible memory control in a microprocessor.

It is a further object of the present invention to allow for boot-up using less expensive ROM (Read Only Memory) in a microprocessor-based system.

It is a further object of the present invention to integrate a flexible Dynamic RAM (DRAM) control interface, a configurable PROM interface and control, as well as general memory interface features onto a single silicon die with a microprocessor and embedded cache

It is further object of the present invention to minimize the cost and board-level complexity of a embedded system.

It is further object of the present invention to generally improve the reliability of a microprocessor-based system, via reduced parts count.

According to the invention, a microprocessor chip includes a central processing unit (CPU), a flexible Dynamic RAM (DRAM) control interface, a configurable PROM interface and control, as well as general memory interface. The CPU has a multi-byte wide (e.g., 32-bit "word-wide") instruction size. Cache control and embedded cache memory are also preferably embedded on-chip with the CPU.

The PROM interface is byte-wide, and enables the CPU to fetch instructions and data in a byte-wise fashion from an 8-bit port, such as an 8-bit wide boot PROM. In order to fetch an instruction (or data) from an 8-bit device, four fetches are required. Code (instructions) can be executed from 8-bit, 16-bit and 32-bit devices, with no external glue logic. A selectable byte-gathering feature is provided. Access times for each byte (or word) is programmable, through a wait state generator (AWG), to allow flexibility in choosing from a wide variety of PROMs with different access times. The WSG is overridable.

Writes to memory over the 8-bit port are simplified by specifying on which eight bits of a wider 32-bit) bus the 8-bit device resides. Instructions are preferably word-aligned.

Dynamic bus sizing is also provided. This is a feature where a 32-bit CPU can accommodate an 8-bit or 16-bit (or 32-bit) wide memory system (e.g., DRAM). The size of the memory device is determined on a per transaction basis. Non-aligned memory fetches are also supported.

The invention minimizes the cost and board-level complexity of a system utilizing the microprocessor.

Other objects, features and advantages of the present invention will become evident in light of the following description thereof.

In the description, the following terms and abbreviations are or may be used: central processing unit, or processor (CPU), Random Access Memory (RAM), Read Only Memory (ROM), Programmable ROM (PROM), Dynamic RAM (DRAM), Static RAM (SRAM), Input/Output (I/O), kilo (k). Further various signals are designated by generally accepted acronyms, such as enable (EN), read (RD), write (WR), fetch (FTCH), memory (M), data (D), instruction (I), test (TEST), acknowledge (ACK), block (BLK), etc., which may be compounded to provide descriptive signal names. In some cases, these signals are followed by a notation [##:#] or (B##..B#) which indicates byte-wide signals, and their bit count.

BRIEF DESCRIPTION OF THE DRAWINGS

Figure 1 is a block diagram showing the system architecture of the present invention.

Figure 2 is a block diagram of an exemplary 8-bit boot PROM interface, according to the present invention.

Figure 3 is a block diagram of an exemplary 32-bit boot PROM interface, according to the present invention.

Figure 4 is a more detailed block diagram of the bus interface unit (BIU) shown in Figure 1.

Figure 5 is a block diagram of an external DMA bus master, corresponding to the system architecture shown in Figure 1.

DETAILED DESCRIPTION OF THE INVENTION

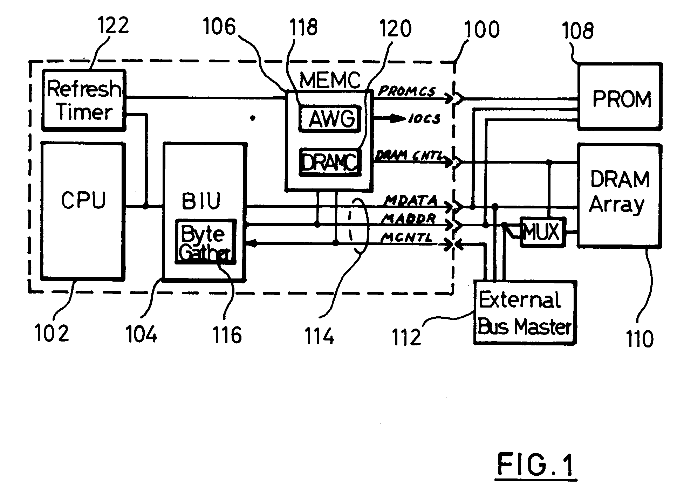

Figure 1 shows a microprocessor 100 which includes the following major elements: a central processing unit (CPU) 102, a bus interface unit (BIU) 104, and a memory control unit (MEMC) 106. The microprocessor 100 may also contain embedded ("on-chip") cache memory (not shown), which is disclosed in the aforementioned U.S. Patent Application No. (Attorney Docket No. LLC-2013).

CPU 102

An LR3000 Microprocessor, available from LSI Logic Corporation, Milpitas, CA, is suitably employed for the CPU 102. The LR3000 Microprocessor is a MIPS (trademark of MIPS Computer Systems Inc.) RISC (Reduced Instruction Set Computer) microprocessor, and includes on-chip memory management, cache interface and control and main memory control logic. The LR3000's on-chip memory management function is fully associative, employing a 64-entry translation lookaside buffer. The on-chip cache control manages separate external instruction and data caches, of up to 356 Kbytes each, both of which can be accessed during a single CPU cycle. The LR3000 generates all the required cache and main memory control and address signals for attached coprocessors.

A more detailed description of the LR3000 Microprocessor is contained in a specification sheet (preliminary, 1988) appended hereto as Appendix 1 and available from LSI Logic. As noted therein, the LR3000 defines a 32-bit word, a 16-bit half word and an 8-bit byte. The byte ordering is configurable into either big-endian or little-endian byte ordering. All LR3000 instructions are 32 bits in length, and the LR3000 includes a 32-bit internal bus. The existing LR3000 is configured to boot up from a 32-bit boot PROM only. According to the present invention, boot-up from either 8-bit or 32-bit boot PROMs is supported.

The "normal" signal configuration of the LR3000 Microprocessor includes:

a) a 32-bit (D31:0) bidirectional Data Bus carrying all data and instructions between the CPU, caches, main memory and coprocessors;

b) an 18-bit (AdrLo 17:0) Address Low Bus carrying low-order address bits to the caches and memory subsystem. Only the 16 most significant bits (AdrLo 17:2) are used to access cache locations;

c) a 20-bit (Tag 31:12) Tag Bus transferring cache tags into the CPU during cache reads. During cache writes, the tag bus carries tag bits into the cache. For main memory accesses, the 16 most significant bits are combined with the AdrLo bus to form a 32-bit physical address;

d) a Tag Valid (TagV) signal carrying the valid bit between the LR3000 and the caches. During cache reads, TagV is used as one of the criteria in determining whether a cache hit has occurred;

e) a 3-bit (TagP2:0) bidirectional Tag Parity bus containing parity for the Tag Bus and the Tag Valid signal. Tag Parity is generated for cache writes, and is checked during cache reads. A tag parity error is treated as a cache miss.

f) I-Cache Read (IRd1 and IRd2)and D-Cache Read (DRd1 and DRd2) signals, which are asserted during I-Cache and D-Cache read operations to enable the outputs of the cache RAMs;

g) I-Cache Write (IWr1 and IWr2) and D-Cache Write (DWr1 and DRw2) signals, which are asserted during I-Cache and D-Cache write operations. These signals are typically used as the write-enable or write-strobe inputs to the cache RAMs; and

h) I-Cache Latch Clock (IClk) and D-Cache Latch Clock (DClk) signals, which are asserted during every cycle, and are used to latch addresses into external latches and onto the address bus for the cache RAMs.

External to the microprocessor, or "off-chip", are a boot-up PROM 108, a DRAM array (for main memory) 110, and external bus master control logic 112. The function of these elements, generally, is well known in the art to which this invention most nearly pertains.

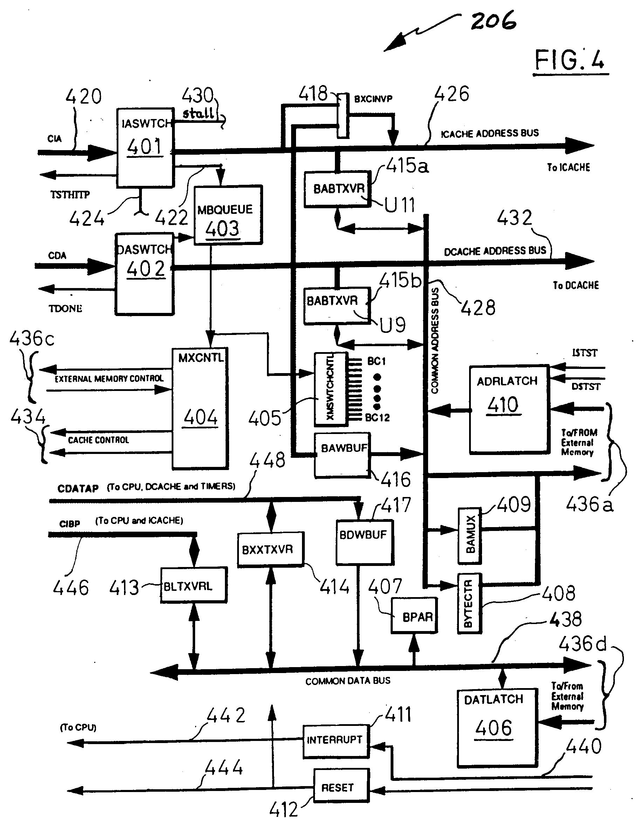

The Bus Interface Unit (BIU) 104 provides an interface between the CPU 102 logic and a general purpose (external) memory bus 114, and is described in greater detail with respect to Figure 4, below. The external memory bus 114 is similar to existing buses in that it contains various control signals (MDATA, MADDR, MCNTL) which control a bus transaction, or memory data transfer, and is accessible external the chip 100.

A data transfer on the external bus 114 may consist of a single word read, a block read of 2, 4, 8 or 16 words, or a write of from one to four (8-bit) bytes within a 32-bit word.

Additionally, the BIU contains a logic block 116 for byte-gathering. When a bus read transaction is initiated, and the MBYTEWIDEN (described below) input signal is active, the BIU will perform byte-gathering. This allows for the use of a single 8-bit boot-up memory device 108, which can save on cost and board area. When byte-gathering, the BIU 104 will perform four read transactions per word to bet each individual byte, and gather the bytes into a holding register. The order of the bytes in a 32-bit holding register will depend on whether "big endian" or "little endian" ordering is specified. Once four bytes have been gathered, the data word (or 32-bit instruction) is passed on to the CPU 102 using the internal CPU/BIU protocol.

The MEMC control block 106 resides outside of the BIU, but is preferably on the same physical die. It contains two largely independent units: an automatic wait state generator (AWG) 118 which provides chip select control (IOCS) for two independent memory chips or memory arrays, and a Dynamic RAM control (DRAMC) block 120 which provides all of the control logic for a single bank of DRAMs (e.g., 110).

Flexible options allow for the use of various speed DRAM devices, and "hooks" are provided for interleaved DRAM banks with simple external control.

DRAM refresh control is also provided by the DRAMC block 120, in concert with a refresh timer 122. The refresh timer is preferably on the same physical die as the CPU.

## AWG 118

An automatic wait state generator (AWG) is provided to reduce the need for external logic to access various external devices, including various PROMs 108. The AWG independently controls two address spaces, one for PROM instructions and another for IO data. When MXSTARTN is asserted, the appropriate chip select output is asserted low. The value of the appropriate wait field (WAIT not shown) is then used to count cycles. If the WAIT field value is zero, no wait states are inserted and the chip select signal (CS) is de-asserted in the next cycle. The data ready signal (DRDYN) is internally asserted when the internal wait state generator counts to zero, to signal a sequence termination to the BIU.

If an externally generated DRDYN signal is applied before the internal DRDYN signal, the external signal will terminate the cycle and cause the CS to be de-asserted. This feature allows for the use of EPSELN of IOSELN to select devices with different access times in the same address range.

The PROM wait field (PWAIT) is set to 15 on a reset. This allows for fetching an exception vector and power-on boot program. The boot program may at any time change the PWAIT value to a smaller number to take advantage of a faster PROM chip.

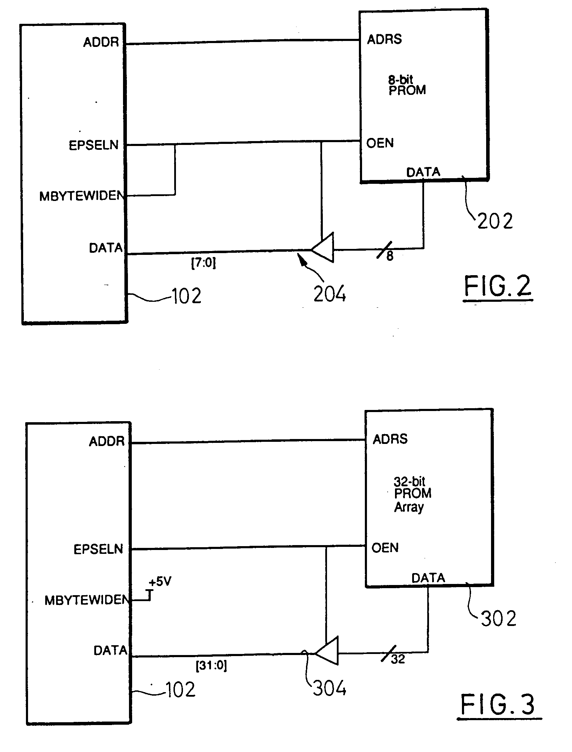

Additionally, if the EPSEL signal is asserted and the MBYTEWIDEN signal is asserted low, the CPU will go into an 8-bit bus mode (See Figure 2, EPSELN connected to MBYTEWIDEN).

Further description of the AWG is found in Appendix 5 ( COBRA Microprocessor Memory Interface).

## Bus Interface Unit (BIU) 206

The Bus Interface Unit (BIU) 206 is the intermediary logic between the CPU 202, the cache 204, and other system components such as timers and DRAM control. It controls the CPU interface to external memory, as well as to on-chip instruction and data caches (ICache and DCache).

Figure 4 shows functional layout of the BIU 206, which includes the nineteen functional blocks shown. The functions of these blocks are described in detail in Appendix 6. In this section, the blocks are described only briefly, or in greater detail as they are relevant to the present invention, particularly for entering a test mode for direct cache read/writes.

An Instruction Address Switch (IASWTCH) block 401 determines if an off-chip memory transaction is required and issues a stall request 430 in response thereto. This includes times when an instruction fetch is required, and when bus snooping is being performed.

A Data Address Switch (DASWTCH) block 402 is analogous to the IASWTCH, except that it performs services for data memory transactions.

A Memory Block Queue (MBQUEUE) block 403 maintains information pertaining to external memory access, including a) an external memory start bit (BTXSTART), b) an instruction/data transaction bit (BIPDN), c) a cacheable/non-cacheable transaction bit (BNCABLEP), and d) a read/write transaction bit. The queue can be parallel loaded. The presence of a transaction start bit (BTXSTART) at the head of the queue causes external memory access to be started using the information from the head of the queue. Information at the head of the queue is also used to configure the BIU data paths to provide information from the correct source to the correct destination. When an external memory transaction for the request at the head of the queue has completed, the contents of the queue are shifted so that the next queued access is brought to the head and the external memory transaction for that request is started.

A memory transaction control (MXCNTL) block 404 issues external memory control signals and responds to external control inputs. The MXCNTL block issues memory control sequences to the CPU based upon information in the queue of the MBQUEUE block 403.

An external memory switch control (XMSWTCHCNTL) 405 controls the BIU data path configuration during various operations, by issuing a number of data path control signals BC1-BC12.

A data latch (DATLATCH) block 406 is used to sample data on the external memory data bus 436, passing it through to or from a common (internal) data bus 438. This data latch is complicated by the byte-gathering required by the 8-bit port feature on bits 7-0 of the data bus. Loading of each byte is individually controlled by another block (BYTECTR, described below).

A block parity (BPAR) block 407 checks parity on read operations. Data (i.e., instructions and data) is provided to this block via the DATLATCH 406 from the external memory data bus 436. If a parity error is found, this block generates a parity error signal to the CPU.

A byte counter (BYTECTR) block 408 is used to generate the byte address in an 8-bit port fetch where byte gathering is done. This block contains a loadable modulo-4 counter. The address bits [1:0] are loaded into this counter and the bytes are incremented modulo-4 until the four bytes have been fetched. This block controls the way bytes are gathered in the DATLATCH block 406 depending upon the byte-order (endianness) configuration.

A block address multiplexer (BAMUX) block 409 multiplexes the proper number of bits onto the external memory address bus 436 so that a block address is generated for DRAM or other accesses. The incrementation of the block address takes place in the MXCNTL block 404.

An address latch (ADRLATCH) block 410 latches bus snooping addresses when the external bus is granted.

An interrupt (INTERRUPT) block 411 latches external interrupt signals on a line 440 and passes them on to the CPU 202 over a line 442.

A reset (RESET) block 412 ("BRST" in Appendix 6) generates reset signals on a line 444 for cold and warm resets of various elements of the BIU, as well as for the CPU.

A block transceiver latch (BLTXVRL) 413 connects a latched version of the BIU's common data bus 438 to the CPU's (32-bit) instruction bus (CIBP) 446, via 3-state transceivers.

A bus transceiver latch (BXXTXVR) 414 connects the CPU's data bus (CDATAP) 448 to a latched version of the BIU's common data bus 438 via 3-state transceivers.

An address bus transceiver (BABTXVR, U11) 415a connects the instruction cache's address bus 426 to the BIU's common address bus 428 via 3-state transceivers.

A second address bus transceiver (BABTXVR, U9) 415b connects the data cache's address bus 432 to the BIU's common address bus 428 via 3-state transceivers.

A bus address write buffer (BAWBUF) 416 forms an address portion of the write buffer function. In this block, addresses for write transactions are stored until used by an external write transaction.

A bus data write buffer (BDWBUF) 417 forms a data portion of the write buffer function. In this block, data for write transactions are stored until used by an external write transaction.

A cache invalidation (BXCINV) block 418 contains a multiplexer which is used to place an invalidation address on the ICache address bus 426.

PROM Interfaces

Figure 2 shows an exemplary interface between an 8-bit PROM array 202 and the CPU 102. If a basic 8-bit PROM or EPROM is used as the boot device, and speed is not critical, interfacing to the CPU is relatively easy. The only extra chip required would be an 8-bit tristate driver (not shown) due to the relatively long tristate disable times for most slow PROMs. For interfacing to an 8-bit PROM, the external PROM select (EPSEL) output of the CPU is connected to the MBYTEWIDEN signal to signify an 8-bit port. When asserted in this manner (active low) this signal (BYTEWIDE) indicates that the memory interface is 8 bits wide. Having detected this signal, the CPU will fetch four bytes from the 8-bit PROM 202, beginning at the byte address generated, until the complete addressed word has been collected (gathered).

When asserted (active low), EPSEL indicates that the CPU is accessing the PROM address space, and can be used as a chip select signal. The CPU will generate its own data ready (DRDY) signal a programmable number of wait states after the transaction begins. The external PROM logic may override the internal wait state generator 118 and use the DRDY signal to control the number of wait states.

This interface uses the AWG (118, Figure 1) feature to eliminate external control logic. After a power on reset, instructions and data will be fetched from the PROM 202 with 15 internal wait states (see AWG 118), until software changes in a wait field (PWAITT) in the configuration register.

Figure 3 shows an exemplary interface between a 32-bit PROM array 302 and the CPU 102. A singular difference between the interface to the 32-bit PROM 302 is that MBYTEWIDEN is pulled high (+5v) to indicate a 32-bit bus 304.

A signal MXSTARTN (not shown) is activated for one (microprocessor) cycle to signal the start of a transaction. At the same time, MADDR is applied, as well as a signal MIPUN (not shown), which signals that an instruction is being fetched when high; a signal MPWRN (not shown) which signals whether the transaction is a read or write; and a signal BLKFREQP (not shown) which when high requests a block fetch transaction.

A signal MASH (not shown) is asserted one clock phase later.

A signal MRDN (not shown) is asserted with the same timing as MASN, if it is a read transaction being requested.

A transaction is completed when a MRDYN input (not shown) is sampled low by the BIU 104. MADDR and all MCntl except a signal MXSTART (not shown) will be held until the end of the transaction.

DMA Operation

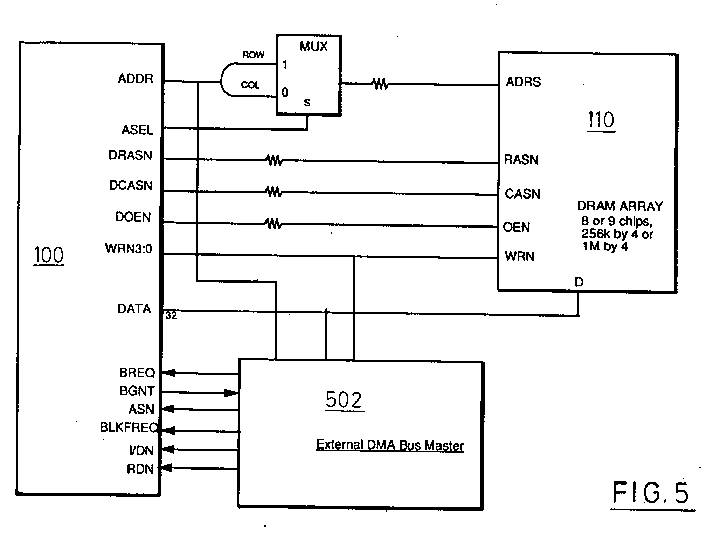

Figure 5 is similar to Figure 1, and details the operation of an external DMA (Direct Memory Access) Bus Master 502 (corresponding to the external bus master 112 of Figure 1). The microprocessor 100 provides "hooks" for allowing the external DMA controller 502 to access DRAMs 110 which are being controlled by the on-chip DRAM controller (120, Figure 1). This allows inexpensive expansion of the basic microprocessor without the need to go to external control logic for the DRAMs, and is described in greater detail in Appendix 5 (COBRA Microprocessor Memory Interface; see pages 14-15 therein.) This provides the ability to support external bus master (such as DMA) access to DRAMs, including block data fetches.

When the DMA 502 requires a DRAM cycle, it asserts a signal BREQ to obtain control of the bus. When a signal BGNT is asserted by the microprocessor 100, the DMA 502 then has control of the bus and can assert the desired DRAM address on the MADDR lines, and the desired action on the control signals RDN, I/DN and BLKFREQ, and then asserts ASN low to initiate a transaction. The DRAM controller, when BGNT is asserted, monitors these lines and takes appropriate action when ASN is sampled low. If RDN is asserted high, a DRAM write cycle is initiated. If RDN is asserted low, a read cycle is initiated. Likewise, if BLKFREQ is asserted, a fast page mode block sequence is initiated. The size of the block is determined by the I/DN signal. If I/DN is high, the instruction block size is used. Otherwise the data block size is used, as programmed into the memory configuration register.

This feature has an advantage over prior integrated DRAM controller designs in that this design allows access to DRAMs either from the on-chip microprocessor or an off-chip bus master.

6

Appendices

Further description of the above can be found in the following documents, appended hereto:

1. <u>LR3000 High Performance RISC Microprocessor (Preliminary)</u>, September, 1988, LSI Logic Corporation, Milpitas, CA (Order No. LR3000).

2. <u>Module Definition of the Cache Megacell</u>, Sanjay Desai, December 7, 1989 (Rev. 3.0 dated 9/25/90), LSI Logic Corporation, Milpitas, CA.

3. <u>BIU Module Definition</u>, Michael L Fuccio, December 4, 1989 (Rev #1.0 dated 1/8/90), LSI Logic Corporation, Milpitas, CA.

4. <u>COBRA-MIPS High Performance Embedded Processor (Preliminary)</u>, April 30, 1990, (Rev. 1.6), LSI Logic Corporation, Milpitas, CA.

5. <u>Cobra Microprocessor Memory Interface</u>, June 20, 1990, (Version 1.2), LSI Logic Corporation, Milpitas, CA.

6. <u>BIU Module Block Descriptions</u>, Michael L. Fuccio, August 29, 1990 (Rev. #1.2, 10/4/90), LSI Logic Corporation, Milpitas, CA.

7. <u>On an 8-bit bus size</u>, Michael L. Fuccio, December 14, 1989, LSI Logic Corporation, Milpitas, CA.

**Claims**

1. A microprocessor (100), comprising:
   - a central processing unit CPU (102) with a word-wide internal bus having a multi-byte width;
   - a memory bus (114) for receiving instructions and data from an external boot PROM (108);
   - a bus interface unit BIU (104) for providing signals from the memory bus (114) to the CPU (102); and
   - byte gathering means (116) selectively enabled for gathering multiple bytes on the memory bus (114) from a byte-size or multi-byte-size boot PROM (108) into wider words for presentation on the internal bus, and bypassed for providing words directly to the internal bus.

2. The microprocessor according to claim 1, further comprising embedded cache memory (204) sharing the internal bus; and wherein multiple bytes or words are provided by the BIU (104) from the boot PROM (108) to the cache memory (204).

3. The microprocessor according to claim 1 or 2, wherein all of the elements are contained in a single chip.

4. The microprocessor according to claim 1, 2 or 3, wherein the internal bus is 32-bits wide; and the byte width is 8-bits.

5. The microprocessor according to any preceding claim, further comprising a configurable I/O interface.

6. The microprocessor according to any preceding claim further comprising the memory control unit (106) including an automatic wait state generator (118).

7. A microprocessor (100), comprising:
   - a central processing unit CPU (102);
   - a memory bus (114) for receiving instructions and data from external dynamic memory DRAM (110); and

- means for providing access to DRAMs (110) either from the CPU (102) or an off-chip bus master (502).

FIG.1

FIG.2

FIG.3

EP 0 480 417 A2

FIG. 4

206

FIG.5